# EUROPEAN PATENT SPECIFICATION

(11) **EP 1 563 547 B1**
(45) Date of publication and mention of the grant of the patent: **26.12.2018**
(21) Application number: 03758398.6
(22) Date of filing: 23.10.2003
(51) Int. Cl.: H01L 33/00, H01L 21/208

(54) **NANOSTRUCTURE, ELECTRONIC DEVICE HAVING SUCH NANOSTRUCTURE AND METHOD OF PREPARING NANOSTRUCTURE**
NANOSTRUKTUR, ELEKTRONISCHE VORRICHTUNG MIT DIESER NANOSTRUKTUR UND METHODE ZU IHRER HERSTELLUNG
NANOSTRUCTURE, DISPOSITIF ELECTRONIQUE COMPORTANT CETTE NANOSTRUCTURE ET PROCEDE DE PREPARATION DE NANOSTRUCTURES

(30) Priority: 05.11.2002 EP 02079617
(43) Date of publication of application: 17.08.2005
(73) Proprietor: Koninklijke Philips N.V., 5656 AE Eindhoven (NL)
(72) Inventor: BAKKERS, Erik, P., A., M., NL-5656 AA Eindhoven (NL); BALKENENDE, Abraham, R., NL-5656 AA Eindhoven (NL); FEINER, Louis, F., NL-5656 AA Eindhoven (NL)
(74) Representative: Rüber, Bernhard Jakob
(86) International application number: PCT/IB2003/004693
(87) International publication number: WO 2004/042830

(56) References cited:
- EP-A- 0 951 047
- WO-A-01/57917
- WO-A-02/17362
- JEONG S-H ET AL: "PREPARATION OF ALIGNED CARBON NANOTUBES WITH PRESCRIBED DIMENSIONS: TEMPLATE SYNTHESIS AND SONICATION CUTTING APPROACH" CHEMISTRY OF MATERIALS, AMERICAN CHEMICAL SOCIETY, WASHINGTON, US, vol. 14, no. 4, April 2002 (2002-04), pages 1859-1862, XP001163195 ISSN: 0897-4756
- LOISEAU A ET AL: "Boron nitride nanotubes" CARBON, ELSEVIER SCIENCE PUBLISHING, NEW YORK, NY, US, vol. 36, no. 5-6, 1998, pages 743-752, XP004124265 ISSN: 0008-6223
- GUDIKSEN M S ET AL: "GROWTH OF NANOWIRE SUPERLATTICE STRUCTURES FOR NANOSCALE PHOTONICS AND ELECTRONICS" NATURE, MACMILLAN JOURNALS LTD. LONDON, GB, vol. 415, 7 February 2002 (2002-02-07), pages 617-620, XP001122834 ISSN: 0028-0836
- GUDIKSEN M S ET AL: "GROWTH OF NANOWIRE SUPERLATTICE STRUCTURES FOR NANOSCALE PHOTONICS AND ELECTRONICS", NATURE, NATURE PUBLISHING GROUP, UNITED KINGDOM, vol. 415, 7 February 2002 (2002-02-07), pages 617-620, XP001122834, ISSN: 0028-0836, DOI: 10.1038/415617A
- SCHMIDT DENEKE ET AL: "SEMICONDUCTOR TUBES, RODS AND RINGS OF NANOMETER AND MICROMETER DIMENSION", PHYSICA E - LOW-DIMENSIONAL SYSTEMS AND NANOSTRUCT, ELSEVIER SCIENCE BV, NL, vol. 13, no. 2-4, 1 January 2002 (2002-01-01), pages 969-973, XP008076878, ISSN: 1386-9477, DOI: 10.1016/S1386-9477(02)00247-3

## Description

The invention relates to a nanostructure of an inorganic semiconductor material according to claim 1.

The invention also relates to a dispersion of nanostructures in a solvent according to claim 5.

The invention further relates to an electronic device comprising a first and a second electrode which are mutually connected through at least one nanostructure according to claim 6.

A semiconductor Light-Emitting Diode (LED) is known in the art. Such a LED comprises a superlattice of active layers. Such superlattices are typically generated by the epitaxial growth of multi-layer active crystals separated by barrier layers. A problem with superlattices is that they are relatively expensive and difficult to produce and the fabrication of superlattices is limited to several material systems including group III-V and group II-VI compounds.

The wavelength of the light emitted by a LED is determined by the bandgap of the semiconductor used. To obtain a high efficiency (electron-photon conversion) a direct bandgap material should be used. For the red (600<λ<900 nm) region in the electromagnetic spectrum several direct-bandgap compound semiconductors, such as AlGaAs, could be used. The efficiency for red-emitting LEDs could be as high as 90%. For the blue (λ∼450 nm) a compound direct-bandgap semiconductor such as GaN could be used, and for the green ((λ∼520 nm) InGaN could be used. However, the efficiency of LEDs emitting wavelengths below 600 nm is low (-10%). The problem, resulting in such low efficiencies, is that the compound (In)GaN material is not mono-crystalline. Non-crystallinity leads to defect states in the bulk of the material. A high concentration of defect states causes radiationless transitions. Also the mobility of the charge carriers is decreased by the high concentration of defects.

Another approach to make a LED is by using semiconducting, single-crystalline nanowires. Compound semiconducting nanowires of the groups II-VI and III-V of the Periodic Table, as well as nanowires of the group IV of the Periodic Table (i.e. silicon) have been synthesized by using the Vapor-Liquid-Solid (VLS) method. The diameter of the wires is in the 5-50 nm range. In this range, the physical dimensions of the material may have a critical effect on the electronic and optical properties of the structure. Quantum confinement refers to the restriction of the electronic wave function to small regions of space within a particle of material referred to as the resonance cavity. Semiconductor structures of which all three dimensions are in the nanometer size range are typically referred to as quantum dots. When the quantum confinement is in two dimensions, the structures are typically referred to as a one-dimensional quantum wire or more simply as quantum wire or nanowire. A quantum wire thus refers to a wire having a diameter sufficiently small to cause confinement to directions normal to the wire. Such two-dimensional quantum confinement changes the wire's electronic properties.

C.M. Lieber and coworkers - Nature 2002, 415, 617-620 - and K. Hiruma and coworkers - Appl. Phys. Lett. 1992, 60, 745-747 - have shown that it is possible to synthesize InP and GaAs quantum wires, respectively, which contain a p-n junction. Electroluminescence was observed when a forward bias was applied to the device. Holes are injected in the p-type part of the wire and electrons in the n-type part of the wire. At the p-n junction the electrons and holes recombine and as a result light is emitted. The emitted light was polarized. The efficiency (electron-photon conversion) was not high (0.1 %). This might be due to surface defect states. No attempts have been made yet to passivate the surface of these III-V materials with established methods. An anneal step in 1 % H₂S in H₂ at 300°C could passivate the surface with sulphur groups increasing the luminescence by a factor of 10-100. Hiruma and coworkers showed that the blueshift of the electroluminescence from the wires, having a diameter of 60 nm, with respect to bulk emission was very small (10 meV). In the work of Lieber and coworkers the blue shift was not quantitatively mentioned. From photoluminescence measurements by Lieber and coworkers on wires with different diameters it was shown that for wires having a diameter of 10 nm the blueshift was 110 meV with respect to bulk emission.

LOISEAU A ET AL, "Boron nitride nanotubes", CARBON, ELSEVIER SCIENCE PUBLISHING, NEW YORK, NY, US, (1998), vol. 36, no. 5-6, ISSN 0008-6223, pages 743 - 752, XP004124265, discloses a nanostructure of Boron Nitride. The nanostructure comprises nanotubes with a crystalline mantle and a hollow core.

SCHMIDT DENEKE ET AL, "Semiconductor tubes, rods and rings of nanometer and micrometer dimension", PHYSICA E - LOW DIMENSIONAL SYSTEMS AND NANOSTRUCT, ELSEVIER SCIENCE BV, NL, vol. 13, 2-4, 1 January 2002 (2002-01-01) pages 969-973, XP008076878, discloses InGaAS/GaAs nanotubes having an inner diameter of 15 nm.

It is a disadvantage that such a blueshift is still rather small. The standard wavelength of InP for instance is in the infrared spectrum, and the blueshift observed is not enough to provide light with wavelengths.

It is thus a first object of the invention to provide nanostructures with a larger blueshift. It is a second object of the invention to provide devices comprising such nanostructures, which devices are able to emit radiation in the visible spectrum.

This first object is achieved by a nanostructure of an inorganic semiconductor material, the nanostructure comprising a nanotube with a crystalline mantle and a hollow core. The inorganic semiconductor is chosen from the group of III-V semiconductor materials. The nanostructure comprises a first zone having a p-type doping and a second zone having an n-type doping, the first and second zones having a mutual interface constituting a pn-junction. Unexpectedly, it has been found that such tubes are formed with a cylindrically shaped crystalline mantle and that they are stable. In the experiments done, the crystal structure was found to be equal to the bulk crystal structure and particularly of the diamond, zinc blend or wurtzite structure. The nanotubes thus formed were mechanically and chemically stable; the tubes did not oxidize upon exposure to ambient air for a week. Further on, the nanotubes could be synthesized as an ensemble of structures all having substantially the same electronic properties. Due to the provision of a pn-junction in the nanostructure, electroluminescent effects are obtained. If desired, the nanostructure can contain two p-n-junctions as well, thus leading to a bipolar transistor.

Even more unexpectedly it was found that the nanotubes show a much larger blueshift of the emission wavelength than nanowires of a compound semiconductor material. This large blueshift is attributed to comparatively thin diameters of the mantle resulting in a larger quantum confinement of the electronic wave functions.

Photoluminescence measurements have shown that the blueshift for InP nanotubes having a diameter of 10 nm and a wall thickness of 3 nm is 800 meV; e.g. the tubes show photoluminescence at a wavelength of 580 nm upon excitation at 514 nm; this indicates that neither surface states nor bulk trap states dominate the electronic properties for which thus the geometric structure appears responsible. This blueshift is such that light emission in the visible spectrum is possible based on electroluminescence. Various desired wavelengths in the entire range of the visible spectrum can be obtained through the choice of the material of the compound semiconductor material, such as InP, GaAs, AlGaAs, GaP, and through the choice and concentration of the dopant, such as S, Se, Te, Zn. It may further be that the nanostructure comprises different materials in different regions.

Nanotubes of other materials, such as carbon and transition metal chalcogenide are known per se. However, these nanotubes have a pseudographitic structure, and the electronic properties are determined by the diameter of the tube and the chirality. It is difficult to dope such nanotubes with a suitable dopant, and it is thus difficult if not impossible to obtain light-emitting behavior. Beyond this, it is impossible to fabricate an ensemble of these nanotubes such that all nanotubes have the same electronic structure.

The overall diameter of the nanotube is preferably in the range of 1-100 nm. The hollow core of the nanostructure has a diameter preferably in the range of 2-20 nm. The crystalline mantle has a diameter preferably in the range of 0.5-20 nm. The nanotube structure may extend over the complete length of the nanostructure. Alternatively, it is limited to a region in the nanostructure, while in other parts of the nanostructure a nanowire structure or a partially filled nanotube structure is present. Such a limitation of the nanotube to a region can be advantageously realized by variation of the growth temperature in a chemical vapor deposition growth process. The limitation has the advantageous effect that the light excitation of a desired material takes place at a specific location. Besides, this dot-structure has an even larger quantum confinement than a complete nanotube. Further on, the nanowire region that may have a larger diameter, allows improvement of the mechanical stability. Such mechanical stability is particularly important if the nanostructures are to be provided in a dispersion onto a surface, and particularly, wherein electrical contact must be established to electrodes, for instance of Au.

The second object is realized in an electronic device comprising a first and a second electrode that are mutually connected through at least one nanostructure that comprises a nanotube with a crystalline mantle and a hollow core. The nanotube comprises a first zone having a p-type doping and a second zone having an n-type doping, the first and second zones having a mutual interface constituting a pn-junction. Herewith a light-emitting diode is obtained, in which the first electrode functions as a hole-injecting electrode and the second electrode as an electron-injecting electrode. Such light-emitting diode can for instance be used for display and lighting applications, as is known per se. However, the device with the nanotubes having a large quantum confinement and a suitable electroluminescent and photoluminescent effect is suitable as well for memory purposes (e.g. quantum dots), for ultrafast transistors and for optical switches, optocouplers and photodiodes (to convert an optical signal into an electrical signal or to do the reverse).

The device of the invention can have various forms. It is advantageous if the nanostructures are present in an array within a layer, this layer separating the first and the second electrode. In this embodiment, the nanostructures are directed substantially transversal to electrodes. Advantages of this "vertical" type of device include that no assembly of the nanostructures is necessary and that an array of nanostructures can be used for interconnecting both electrodes.

The layer in which the nanostructures are present can be provided before the growth of the nanostructures, e.g. as a porous matrix of for instance alumina. However, it can be provided afterwards as well, e.g by growing the nanostructures and providing the layer from solution afterwards. A very suitable manner of providing such layer is sol-gel processing. A particularly advantageous layer comprises a mesoporous silica which may contain organic substitutions. Such a layer has a low dielectric constant, which reduces undesired capacitive interaction between the first and the second electrode. Alternatively, a polymer can be used that is transparent if optical properties of the nanostructures are to be exploited. This has the advantage that a flexible device can be obtained.

The array type of device is particularly suitable in combination with a nanostructure including a p-n-junction. Such an array will result in a very high light output power density. If the array has a density of 10¹⁰ pores and hence nanostructures per cm², the power density can be in the range of 10²-10⁴ W/cm². Further, due to the crystallinity of the nanostructures, the efficiency of the light emitting diode is high, for instance about 60 %.

In the case where a bipolar transistor in the nanostructure is desired, this can be realized with the matrix containing internal conductors, or in that a conductive layer is provided between two sublayers after growing the nanostructures. Also the growing of the nanostructures may be done in steps such that after a first growth step, a first sublayer is provided. Then the conductor can be deposited, whereafter the growth process is continued in a second growth step, with the same metal nuclei. In order to improve the contact between such internal conductor and the nanostructure, it is preferred that the nanostructure has a mantle with a larger diameter or is a nanowire with a larger diameter at the contact with the internal conductor.

The layer may further be structured according to a desired pattern. This is particularly advantageous if the nanostructure is used as a photodiode. In that case the layer can be structured so as to have a fiber-like shape. Around the structured layer black or non-transparent layers can be provided, so as to keep the light inside the layer.

In a further embodiment, the layer contains nanostructures of different materials. Herewith a multicolor light-emitting device is realized. The nanostructures of different materials can be provided in that a plurality of growth cycles is done, with first the provision of the nuclei, generally a droplet of a metal and then the growth at one or more desired growth temperatures, and then the removal of the nuclei, so as to stop the growth.

If used as a light-emitting diode, at least one of the electrodes is preferably transparent. At the side of the layer opposite to the transparent electrode, a reflecting layer may be present, so as to increase the efficiency of the light output.

Nonetheless, the advantages of the vertical device type, the nanostructures of the invention may be present in a thin-film device type, wherein the first and second electrodes are laterally spaced apart. A dispersion with the nanostructures, for instance in ethanol as dispergent, is then provided onto the electrodes. The alignment of the nanostructures and the electrical contacting between electrodes and nanostructures can be realized in a manner known per se, as is also disclosed by Lieber and coworkers.

The nanostructures of the invention can be suitably and easily made.

This is realized in that the growth temperature is above a transition temperature, therewith obtaining nanotubes. Below this transition temperature nanowires or partially filled nanotubes are obtained. The transition temperature depends on the type and the concentration of dopants. It lies around 500 °C for InP. If desired, the nanotubes obtained can be thinned by oxidation. However, due to further increase of the temperature the thickness of the mantle can be reduced adequately.

The nuclei used as growth catalysts in the method of the invention are chosen from a suitable metal or a colloidal particles including such metal. Examples of suitable metals are Co, Ni, Cu, Fe, In, Ga, Ag and Pt.

These and other embodiments of the nanostructure and the device of the invention as well methods to make the nanostructure will be further explained in the Figures and tables, in which:
Fig. 1 shows a method of preparing the nanotubes;
Fig. 2 shows electronmicroscopy images of the nanotubes; Table 1 shows data regarding the transition temperature;
Fig. 3 shows a plot of the mantle thickness d (nm) of a InP nanotube versus the substrate temperature T (°C);
Fig. 4 shows a Figure wherein the intensity I of emission is shown for InP nanotubes (graph A), InP nanowires (graph B), and InP nanotubes (graph C) as a function of the wavelength λ;
Fig. 5 shows TEM images of a partly hollow InP tube induced by dopant atoms;
Fig. 6 shows a first method of manufacturing the electronic device of the invention;
Fig. 7 shows a second method useful for understanding the manufacturing of an electronic device; and
Fig. 8 shows a third method useful for understanding the manufacturing of an electronic device.

The Figures are schematical and not drawn to scale. Like reference numbers in different Figures refer to the same or similar parts. The Figures and the description are merely examples and should not be considered to set the scope of the present invention.

### Example 1 useful for understanding the invention

InP nanotubes were synthesized with the VLS growth method, by analogy with semiconducting nanowires, but at higher temperatures. A silicon substrate provided with an oxidized surface ("native oxide") and thereon a thin (2-10 Å) Au film was placed on an Al₂O₃ block in a tube oven at the downstream end. The substrate temperature was measured 1 mm below the substrate in the Al₂O₃ block. The oven is evacuated to less than 10 Pa. Thereafter, the pressure is set to 3.10⁴ Pa with a 100-300 sccm flow of Ar. The oven is heated to 500 °C resulting in the splitting of the Au layer into clusters on the scale of nanometers. At the upstream end of the oven an InP target (density 65%) is positioned and with an ArF laser (λ = 193 nm, 100 mJ/pulse, 10 Hz) the InP is ablated from the target. The InP is vaporized and transported over the substrate. This results in the growth of nanostructures under the catalysis of the Au-clusters.

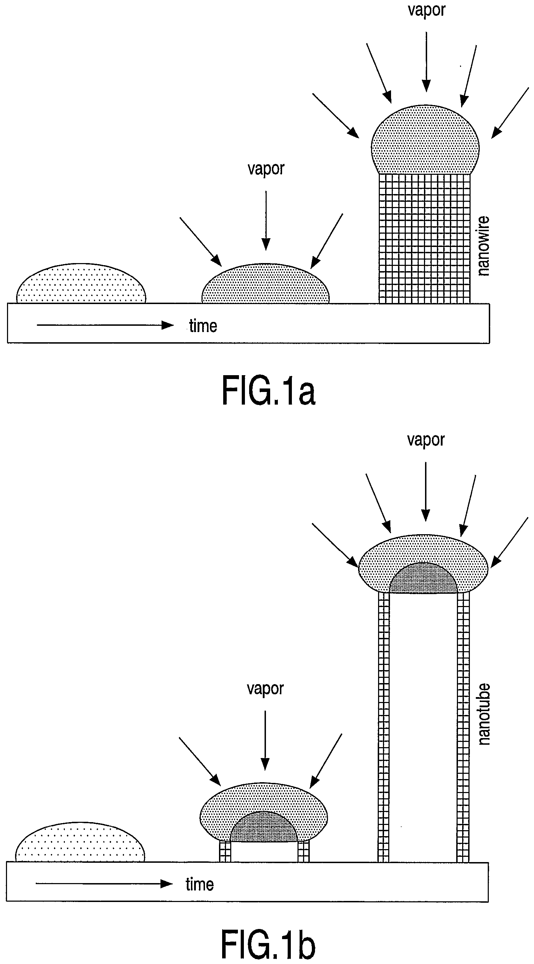

Fig. 1 shows schematically the temperature-dependent growth of the nanostructures. At relatively low substrate temperatures (<500°C) the wire growth is limited by the crystal growth rate at the liquid-solid interface. The semiconductor species are homogeneously distributed throughout the liquid droplet and a solid semiconducting nanowire is formed. At higher substrate temperatures (>500°C) the reaction becomes diffusion-limited; the diffusion of semiconducting species through the liquid droplet is relatively slow compared to crystal growth. The concentration of the semiconductor species becomes depleted and for geometry reasons the crystal growth starts circularly. As a result, nanotubes having a crystalline mantle and a hollow core are formed. The applied substrate temperature determines the overall diameter of the tube and the mantle thickness.

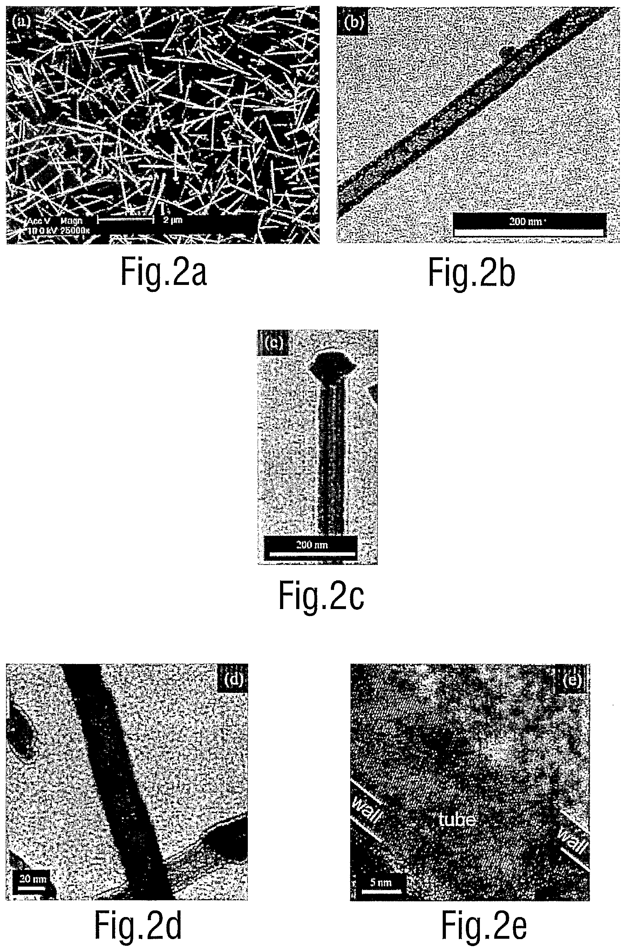

Fig. 2 shows SEM and TEM images of InP nanotubes grown at 515°C on a silicon substrate. The SEM images were made with a Philips XL40FEG apparatus. The TEM images were made with a TECNAI TF30ST apparatus. Fig. 2a shows a SEM image. From this SEM image it is clear that over 95 % of the deposited material consisted of wire-like structures. Fig. 2b and 2c show TEM images. This allows a closer examination that reveals that hollow tubes were formed. Judging from the contrast from both bright field TEM and HAADF (high-angle annular dark field) imaging it was clear that there was no material present in the core of the tubes. As can be seen in Fig. 2c, the tubes were terminated by a spherical particle which contained gold. This indicates that the tubes grow from the liquid InP-Au phase via the VLS mechanism. The diameter of the tubes was uniform along their length.

Figs. 2d and 2e show TEM image of a further InP nanotube, which was doped with Zn and grown at 520°C. In Fig. 2 a darker contrast in the mantles - also called walls - of the tube is present. This is a diffraction contrast originating from the crystalline nature of this tube. Upon tilting the sample with respect to the electron beam diffraction, contrast fringes can be seen to move over the entire width of the tubes, implying a cylindrical shape of the crystals. The observation that the diffraction contrast is most pronounced in the walls again confirms the hollow nature of the tubes. The thickness of the wall of the nanotube shown in the HRTEM image (Figure 2(e)) was approximately 4 nm. The crystal lattice corresponded to the InP zinc blend lattice and the tubes were grown in the [200] direction. The tubes did not oxidize upon exposure to ambient air for a week.

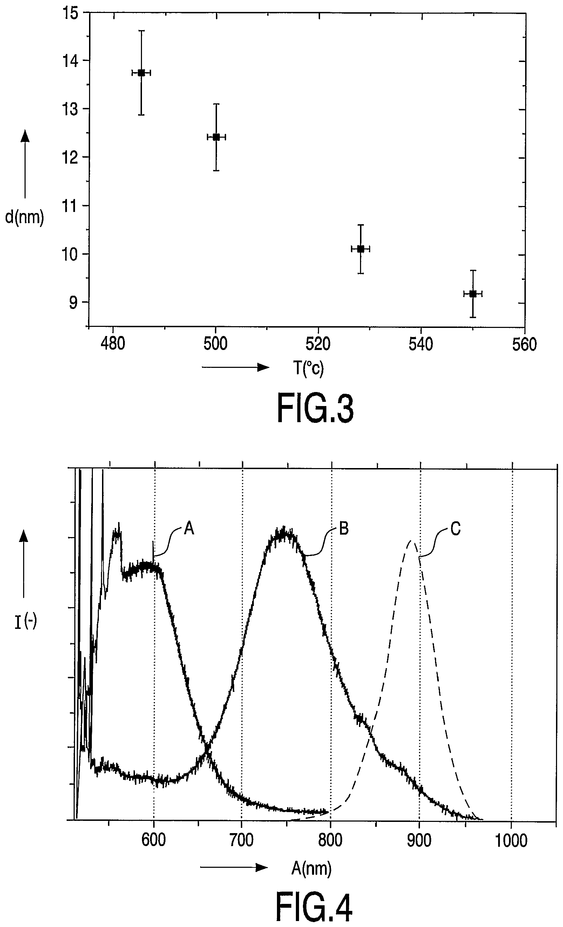

Fig. 3 shows a graph of the mantle thickness d versus the substrate temperature T, for the nanotubes prepared as mentioned above. The thickness decreases from about 14 to 9 nm while the temperature is increased from 490 °C to 550 °C. At about 500 °C the transition from nanowires to nanotubes takes place. This is found back in the graph in that the decrease in thickness is relatively steep around this transition temperature.

Fig. 4 shows a diagram wherein the intensity of the light emission is plotted against the wavelength λ in nm. Three graphs are shown: one for InP nanotubes (graph A), one for InP nanowires (graph B) and one for Bulk InP (graph C). The data for the nanotubes are based on the nanotubes obtained as described above, with a mantle thickness of 4 nm. The data for the nanowires are based on nanowires with a diameter of 5 nm which were prepared with the VLS method at a temperature below 500 °C. The measurements are photoluminescence measurements, wherein the samples were irradiated with a Ar laser with a wavelength of 514nm. As is clear from this Figure, the emission of the nanotubes takes place at a wavelength that is remarkably much smaller than the wavelength of the InP nanowires and of bulk InP. Particularly, the emission of the nanowires has blueshifted 150 nm (250 meV) with respect to the bulk emission. The emission of the nanotubes has blueshifted 310 nm (750 meV) with respect to bulk emission.

### Embodiment 2

In further embodiments, the growth experiments were repeated. Herewith the targets were changed, so as to contain dopant atoms. In this manner the nanotubes were electrically doped to form p-type and n-type semiconductors. However, the added dopant influences the growth dynamics of the nanotubes. In the presence of dopants a different morphology, *i.e*. nanotubes partly filled with InP crystallites, was also observed. The obtained morphology depended on the dopants added to the InP target and on the substrate temperature.

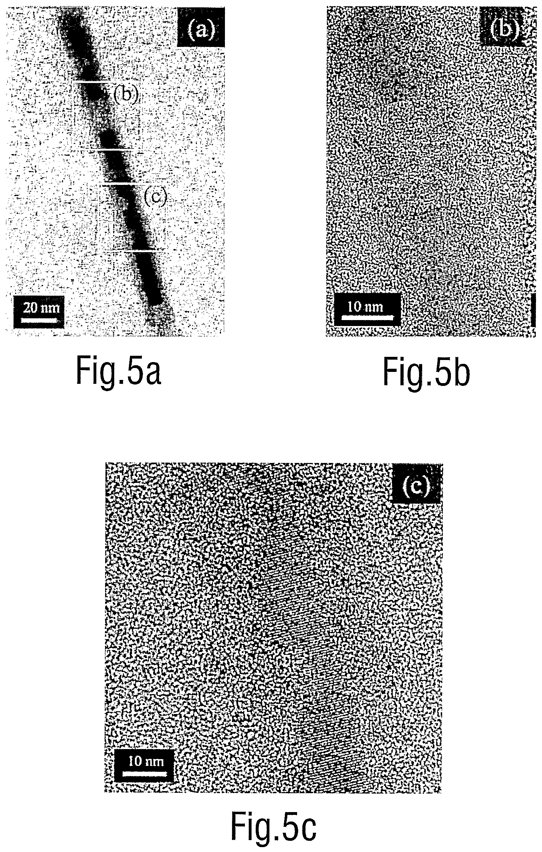

Fig. 5 shows TEM images of such partially filled nanotubes. Figure 5(a) shows a TEM image of a partly hollow tube formed by using an InP target doped with 0.1 mol% Zn at a substrate temperature of 467°C. Figures 5(b) and (c) show HRTEM images of the location where the crystalline core is interrupted. The crystallographic orientation is identical on both sides of the gap. With static SIMS and XPS it was semi-quantitatively shown that dopant atoms were transferred from the target into the wires. When a target dopant concentration of 1.0 mol % with respect to InP was used, an estimated concentration of 10²⁰ atoms/cm³ was present in the wires.

Table 1 shows the morphology obtained when dopants (0.1 or 1 mol %) were added to the target at a given temperature. The target dopant concentration had no influence on the resulting morphology. At the higher temperatures tubes were formed and at the lower temperatures solid wires. At intermediate temperatures the partly filled tubes were observed.

**Table 1. The obtained morphology in the indicated substrate temperature range when a dopant was added to the InP target.**

| Dopant | Solid wire | Partly filled | Hollow tube |
|---|---|---|---|
| No dope | T<500°C | - | T>500°C |
| S | - | 460<T<480°C | T>480°C |
| Se | T<485°C | 485<T<530°C | T>530°C |
| Te | T<500°C | no data | No data |
| Zn | T<450°C | 450<T<515°C | T>515°C |

### Embodiment 2

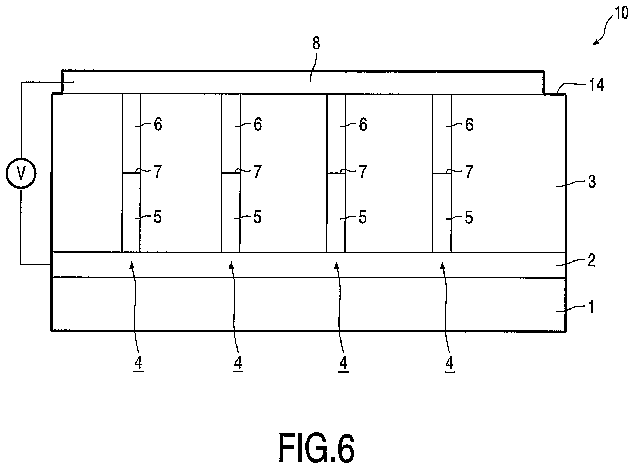

Fig. 6 shows an embodiment of the present device 10 comprising a light-emitting diode. The device 10 comprises a substrate 10 on which a first electroconductive layer is present in which the first electrode 2 is defined. The substrate 1 is made of insulating material, e.g. Al₂O₃ in this case and the conductive layer comprises Ti in this example. The conductive layer 2 is connected to pixel switches and a driver circuit that are not shown. However, these pixel switches, for instance transistors of polysilicon or amorphous silicon, can be provided in the substrate 1. On the first electrode 2 a porous matrix 3 is present, of which the pores are filled with nanotubes 4 of InP having a first region 5 that is p-type doped with a first dopant of Se and a second region 6 that is n-type doped with a second dopant of Zn. A p-n-junction is present at the mutual interface 7 of the first and the second region 5,6. At the upper surface 14 of the porous matrix a second, transparent electrode 8 of ITO is present. This stack constitutes the light-emitting diode. Preferably, a plurality of light emitting diodes is present on the substrate 1, as the skilled person will understand.

The diode is manufactured as follows. After provision of the first electrode 2 by sputtering of a layer of Ti, a matrix 3 of porous anodic alumina was provided. It had a thickness of 0.2 micrometer and a density of pores of 10¹⁰ pores/cm³. These pores, each with a diameter of 20 nm, were vertically aligned. The alumina matrix 3 was manufactured as described in accordance with the method described in WO-A 98/48456.

Nucleus particles, in this example of Au, were then electrochemically deposited at the bottom of the pores. This substrate 1 with the porous matrix 3 was placed in an oven. At the upstream end of the oven an InP target is positioned and with an ArF laser the InP is ablated from the target. The InP is vaporized and transported over the substrate. This results in the growth of nanostructures under the catalysis of the Au-clusters. A first region 5 of the nanotube is grown with an n-type dopant, in this case Se at a temperature of 550 °C. After this the first region has grown with a length of 100 - which, however, may be longer or shorter - the gas composition is changed, and the Se dopant is replaced by a Zn dopant. A second region 6 is grown with this composition, with a length of 120 nm. The first and second regions 5,6 have a mutual interface 7, at which a p-n-junction is present. The upper surface 14 of the matrix 3 is now slightly polished, so as to remove the nucleus particles and the protruding parts of the nanostructures. Thereafter, a layer of indium-tin-oxide (ITO) is deposited in known manner so as to provide the second electrode 8.

### Embodiment 3

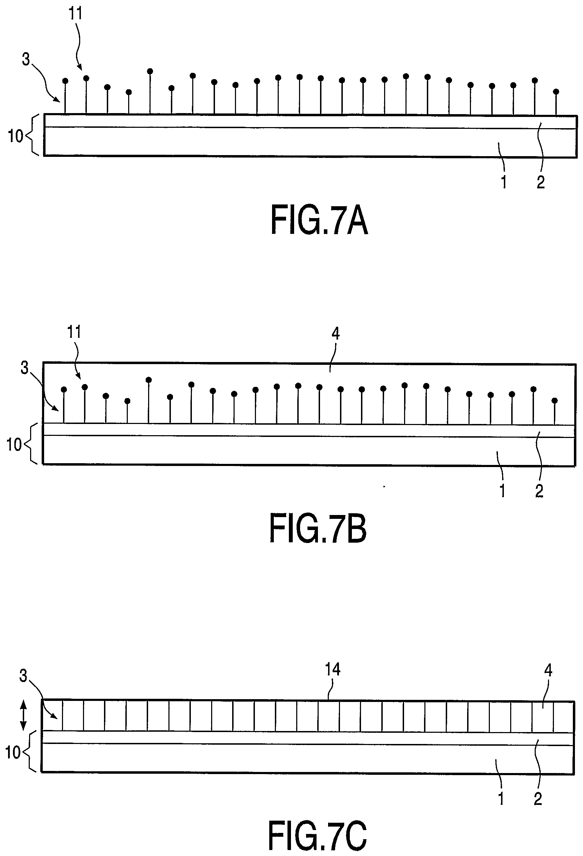

Fig. 7 shows schematically and in cross-sectional view three steps in the method of forming the nanostructure of the invention. Fig. 7A shows a substrate 10 comprising a carrier 1 of borosilicate glass. Thereon, an electroconductive layer 2 is present, which comprises Al. Nanotubes 3 are grown thereon, in a hot film chemical vapor deposition reactor at 550 °C, with nuclei 11, in this case of Au. The nanotubes 4 are grown up to a length of 100-200 nanometers and a diameter of about 10 nanometers.

Fig. 7B shows a second step. Therein a layer of a solution of 2.1 g lead acetate, 9.3 g tetraethoxysilane, 1.9 g trimethylborate and 1.0 triethylaluminate in 80 g ethanol and 10 g acidified water (1 N HCl) was prepared. After hydrolyzing for one hour, the solution was provided on the substrate by means of spincoating. The sol-gel layer provided by spincoating was converted to a glass composition comprising 52.7 wt% SiO₂, 6.4 wt% Al₂O₃, 13.0 wt% B₂O₃ and 27.9 wt% PbO by heating at 300 °C for 45 minutes. The glass was thermally stable to at least 250 °C, which may be advantageous for other process steps. The glass composition may be modified, so as to prevent substantial differences between the thermal expansion of the nanotubes and the glass. The thickness of the obtained solid matrix 4 was 200 nm. Subsequently, the resulting structure was cooled to room temperature. To obtain a layer with a larger thickness, the tetraethoxysilane can be replaced partially by trimethylmethoxysilane and oxidic nanoparticles (silicasol having a solids content of 50%; ludox) are added.

Fig. 7C shows the result of a third step, in which the matrix 4 with the nanotubes 3 is polished so as to expose the ends of the nanotubes 4. The thickness of the matrix is chosen to be between about 150 nm, so as to provide a sufficient aspect ratio. The polishing results in a uniform surface 14. In order to ensure that the ends of the nanotubes 4 are effectively exposed, and not hindered by glass particles, the surface 14 is cleaned after the polishing.

### Example 4 useful for understanding the invention

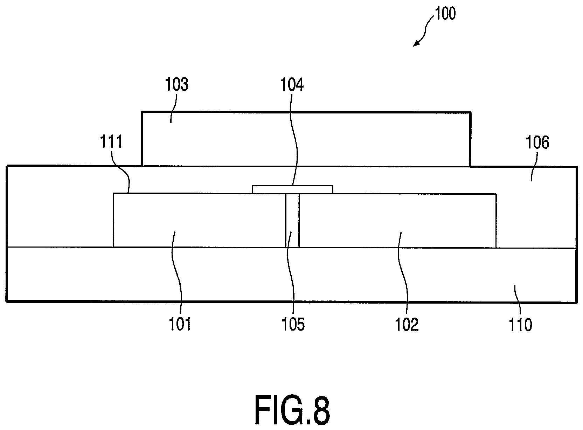

Fig. 8 shows schematically a diagrammatical cross-section of a semiconductor device 100, which is a thin-film-transistor in this case. On a substrate 110 of glass a source electrode 101 and a drain electrode 102 are provided. The electrodes 101,102 comprise Au, for example, and have been defined photolithographically. Other metals such as Al/Ti or Au/Ni/Ge can be used as well. The electrodes 101,102 are mutually separated by a channel 105, which comprises a dielectric material preferably with a low dielectric constant. Suitable materials are known to the skilled person and include silicon oxide, hydrogen and methylsilsesquioxane, porous silica, SiLK and benzocyclobutene. The choice of the material is also dependent on the choice of the substrate. The surface 111 of the electrodes 101, 102 and the channel 105 is planarized, so as to provide the nanostructures 104 on an essentially flat surface 111.

The nanostructures have been manufactured in accordance with Embodiment 1. After immersing the substrate with the nanotubes in a bath of a dispergent, it is ultrasonically vibrated for 2 seconds. As a result hereof, the tubes are dispersed. The dispergent is in this case ethanol, but may for instance be isopropanol, chlorobenze or water as well, or mixtures thereof. Hereafter, a droplet of the dispersion is applied to the surface. Alignment of the nanotubes took place with a technique called flow assembly, wherein a stamp having a stamp surface with desired patterns, including a microfluidic channel, is provided on the substrate 111. Hereafter, an annealing step was carried out to improve the contact between the electrodes 101,102 and the nanotubes 104.

On top of this, a dielectric layer 106 which separates gate-electrode 103 from the nanostructures 104, is present. Therewith the transistor is complete. As will be clear to the skilled person, the electronic device comprises a plurality of transistors and/or other semiconductor elements, such as preferably memory cells and display pixels. As will be clear as well, other constructions of semiconductor devices, thin film transistors in particular, may be provided instead of the field-effect transistor shown, including the construction of a horizontal light-emitting diode.

Particularly if the substrate comprises a semiconductor material, such as silicon, this may be adequately doped to act as gate-electrode, and be provided with an oxide to act as gate oxide material. Preferably, a small channel length, preferably in the order of 0.1-0.3 µm is applied. In this manner, single charge carriers can be put onto the inorganic semiconductor nanotubes, at suitable temperatures, e.g. 77 K and higher. This can be done with excellent result, which is due to the enhanced confinement effect of the nanostructures of the invention, and the reduced self-capacitance resulting from the small channel length. A further advantageous effect is obtainable when using nanotubes having cores that are partially filled with crystallites. The confinement effect is less in these crystallites, leading to charge concentration therein. Thus, the crystallites will act as a quantum well. This quantum well does not only have advantageous effects for storage purposes, but also as a recombination center acting as light emitter. In this manner, the light emitting behavior can be further tuned even without the provision of different materials.

## Claims

1. A nanostructure of an inorganic semiconductor material, comprising a nanotube with a crystalline mantle and a hollow core, the inorganic semiconductor being chosen from the group of III-V semiconductor materials, **characterized in that**, the nanotube comprises a first zone having a p-type doping and a second zone having an n-type doping, the first and second zones having a mutual interface constituting a pn-junction.

2. A nanostructure as claimed in Claim 1, **characterized in that** the hollow core has a diameter in the range of 2 and 20 nm.

3. A nanostructure as claimed in Claim 1 or 2, **characterized in that** the mantle has a thickness in the range of 1-20 nm.

4. A nanostructure as claimed in Claim 1, **characterized in that** the hollow core is partially filled with the compound semiconductor material of the mantle of the nanotube.

5. A dispersion of nanostructures according to any one of the Claims 1-4 in a solvent.

6. A light emitting electronic device comprising a first and a second electrode which are mutually connected through at least one nanostructure according to any one of the Claims 1-4.

7. A light emitting electronic device as claimed in Claim 6, **characterized in that** an insulating substrate with pores that are mutually substantially parallel is present, the pores extending from the first to the second electrode, in which pores the nanostructures are provided.

## Patentansprüche

1. Nanostruktur aus einem anorganischen Halbleitermaterial, umfassend ein Nanoröhrchen mit einem kristallinen Mantel und einem hohlen Kern, wobei das anorganische Halbleitermaterial aus der Gruppe von III-V-Halbleitermaterialien ausgewählt ist, **dadurch gekennzeichnet, dass** das Nanoröhrchen eine erste Zone mit einer p-Dotierung und eine zweite Zone mit einer n-Dotierung aufweist, wobei die erste und die zweite Zone eine gemeinsame Grenzfläche aufweisen, die einen p-n-Übergang bildet.

2. Nanostruktur nach Anspruch 1, **dadurch gekennzeichnet, dass** der hohle Kern einen Durchmesser im Bereich von 2 und 20 nm aufweist.

3. Nanostruktur nach Anspruch 1 oder 2, **dadurch gekennzeichnet, dass** der Mantel eine Dicke im Bereich von 1 bis 20 nm aufweist.

4. Nanostruktur nach Anspruch 1, **dadurch gekennzeichnet, dass** der hohle Kern teilweise mit dem Halbleitermaterialgemisch des Mantels des Nanoröhrchens gefüllt ist.

5. Dispersion aus Nanostrukturen nach einem der Ansprüche 1 bis 4 in einem Lösungsmittel.

6. Lichtemittierende elektronische Vorrichtung, umfassend eine erste und eine zweite Elektrode, die über mindestens eine Nanostruktur nach einem der Ansprüche 1 bis 4 miteinander verbunden sind.

7. Lichtemittierende elektronische Vorrichtung nach Anspruch 6, **dadurch gekennzeichnet, dass** ein isolierendes Substrat mit Poren vorhanden ist, die im Wesentlichen parallel zueinander liegen, wobei sich die Poren von der ersten zu der zweiten Elektrode erstrecken, wobei in den Poren die Nanostrukturen bereitgestellt sind.

## Revendications

1. Nanostructure d'un matériau semi-conducteur inorganique, comprenant un nanotube avec une enveloppe cristalline et un noyau creux, le semi-conducteur inorganique étant choisi par le groupe constitué de matériaux semi-conducteurs III-V, **caractérisée en ce que** le nanotube comprend une première zone ayant une dopage de type p et une deuxième zone ayant un dopage de type n, les première et deuxième zones ayant une interface mutuelle constituant une jonction pn.

2. Nanostructure selon la revendication 1, **caractérisée en ce que** le noyau creux présente un diamètre de l'ordre de 2 à 20 nm.

3. Nanostructure selon la revendication 1 ou 2, **caractérisée en ce que** l'enveloppe présente une épaisseur de l'ordre de 1 à 20 nm.

4. Nanostructure selon la revendication 1, **caractérisée en ce que** le noyau creux est partiellement rempli du matériau semi-conducteur composite de l'enveloppe du nanotube.

5. Dispersion de nanostructures selon l'une des revendications 1 à 4 dans un solvant.

6. Dispositif électronique luminescent comprenant une première et une deuxième électrodes qui sont connectées entre elles par l'intermédiaire d'au moins une nanostructure selon l'une des revendications 1 à 4.

7. Dispositif électronique luminescent selon la revendication 6, **caractérisé en ce qu'**un substrat isolant avec des pores qui sont globalement parallèles entre elles est prévu, les pores s'étendant de la première à la deuxième électrode, les nanostructures étant disposées dans ces pores.
